# EUROPÄISCHE PATENTSCHRIFT

(11) **EP 0 799 845 B1**
(45) Veröffentlichungstag und Bekanntmachung des Hinweises auf die Patenterteilung: **27.11.2002**
(21) Anmeldenummer: 97104454.0
(22) Anmeldetag: 15.03.1997
(51) Int. Cl.: C08G 59/14, C08K 5/53, C08L 63/00, B32B 27/38, H01B 3/40

(54) **Phosphormodifizierte Epoxidharzmischungen**
Phosphorus-modified epoxy resin compositions
Compositions de résines époxydes modifiées par du phosphore

(30) Priorität: 01.04.1996 DE 19613067
(43) Veröffentlichungstag der Anmeldung: 08.10.1997
(73) Patentinhaber: Clariant GmbH, 65929 Frankfurt am Main (DE)
(72) Erfinder: Hörold, Sebastian, Dr., 50374 Erftstadt (DE)

(56) Entgegenhaltungen:
- EP-A- 0 412 425
- DE-A- 2 652 007
- DE-A- 4 308 184
- US-A- 5 294 265
- CHEMICAL ABSTRACTS, vol. 108, no. 20, 16. Mai 1988 Columbus, Ohio, US; abstract no. 168860, XP002091134 & JP 62 275178 A (TORAY IND., INC.) 30. November 1987
- PATENT ABSTRACTS OF JAPAN vol. 012, no. 082 (C-481), 15. März 1988 & JP 62 218465 A (TORAY IND INC), 25. September 1987
- CHEMICAL ABSTRACTS, vol. 121, no. 6, 8. August 1994 Columbus, Ohio, US; abstract no. 59359, XP002091135 & JP 06 080765 A (NIPPON ESTER CO. LTD.) 22. März 1994

## Beschreibung

Die vorliegende Erfindung betrifft phosphormodifizierte Epoxidharzmischungen aus Epoxidharzen, phosphorhaltigen Verbindungen und einem Härter, ein Verfahren zu ihrer Herstellung und ihre Verwendung.

Epoxidharze werden heute zur Herstellung von Formmassen und Beschichtungen mit hohen thermischen, mechanischen und elektronischen Eigenschaften eingesetzt. Sie sind geeignet zum Verguß von elektrischen bzw. elektronischen Bauteilen und für Tränk- und Imprägnierprozesse. In der Elektrotechnik werden die verwendeten Epoxidharz-Formmassen überwiegend flammwidrig ausgerüstet.

Epoxidharz-Formmassen werden im allgemeinen mit bromhaltigen aromatischen Verbindungen, insbesondere Tetrabrombisphenol A, flammwidrig ausgerüstet. Werden ausschließlich bromierte Flammschutzmittel eingesetzt, so wird ein Bromgehalt von etwa 20% benötigt, um ein Selbstverlöschen der Formmassen zu gewährleisten. Als Synergist wird häufig Antimontrioxid verwendet. Im Brandfall wird Bromwasserstoff freigesetzt, was zu Schäden durch Korrrosion führen kann. Unter ungünstigen Bedingungen können auch polybromierte Dibenzodioxine und Furane entstehen. Es besteht von daher ein Bedarf an Epoxidharz-Formmassen, die die geforderte Flammwidrigkeit ohne Zusatz bromierter Verbindungen erreichen.

Zur flammwidrigen Ausrüstung von Epoxidharz-Formmassen wurden Füllstoffe mit Löschwirkung wie Aluminiumoxidhydrat (DE 35 40 524 A1) vorgeschlagen. Auch durch den Zusatz von Ammoniumpolyphosphat, gegebenenfalls in Kombination mit Aluminiumoxidhydrat, kann eine hinreichende Flammwidrigkeit erreicht werden. Anstelle von Ammoniumpolyphosphat kann auch roter Phosphor verwendet werden (DE 17 45 796 A1).

Nachteilig bei allen als Füllstoff vorliegenden Flammschutzmitteln ist, daß keine Transparenz der Materialien erhalten wird. Es wurden bereits zahlreiche flüssige phosphororganische Verbindungen als flammhemmende Kunststoffzusätze vorgeschlagen. Nachteilig bei diesen Systemen ist aber der ausgeprägte "Weichmachereffekt" dieser Zusätze. Bei gehärteten Epoxidharzen äußert sich der weichmachende Effekt in einer starken Herabsetzung der Glasübergangstemperatur.

Die flammwidrige Ausstattung von Epoxidharzen mit epoxidfunktionellen Phosphonsäureestern ist bereits beschrieben (EP 0 384 939 A1). Nachteilig bei diesen Systemen ist der hohe Syntheseaufwand derartiger Phosphonsäureester. In der Literatur bekannt sind auch phosphormodifizierte Epoxidharze, die durch Umsetzung von Polyepoxidverbindungen mit Anhydriden von Phosphonsäuren oder Phosphinsäuren zugänglich sind und sich durch ihre flammwidrige Eigenschaften auszeichnen (DE 43 08 185 A1). Technisch leichter zugänglich als die Anhydride sind carboxyfunktionelle Phosphon- und Phosphinsäuren. Derartige Produkte werden bereits zur flammwidrigen Ausrüstung von Polyesterfasern verwendet.

Aufgabe der Erfindung war es, phosphormodifizierte Epoxidharzmischungen zur Verfügung zu stellen, die eine hohe Flammwidrigkeit aufweisen, leicht herstellbar sind und sich vielseitig einsetzen lassen.

Diese Aufgabe wird gelöst durch flammwidrige Epoxidharzmischungen der eingangs beschriebenen Art, dadurch gekennzeichnet, daß sie eine phosphorhaltige Verbindung der Formel I oder II enthalten.

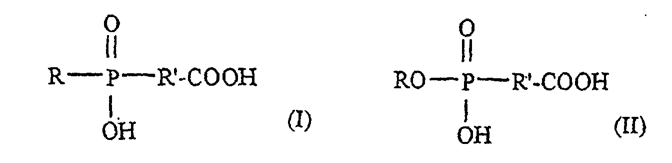

Dabei bedeutet R geradlinige oder verzweigte Alkyl-, Cycloalkyl-, Aryl- oder Alkylarylgruppen mit 1 bis 18, vorzugsweise 1 bis 6 C-Atomen und R' geradlinige oder verzweigte Alkylen-, Cycloalkylen-, Arylen- oder Alkylarylengruppen mit 1 bis 18, vorzugsweise 1 bis 6 C-Atomen und besonders bevorzugt 1-2 C-Atomen.

Bevorzugt enthält die flammwidrige Epoxidharzmischung auf 100 Gewichtsteile Epoxidharz 10 bis 100 Gewichtsteile phosphorhaltiger Verbindungen der Formel I oder II, wobei das Gesamtgewichtsverhältnis von Epoxidharz und phosphorhaltiger Verbindung nach Formel I oder II zu Härter (1 bis 10) zu 1 beträgt.

Bevorzugt ist die flammwidrige Epoxidharzmischung halogenfrei.

Bevorzugt enthält die flammwidrige Epoxidharzmischung 5 bis 300 Gewichtsteile an phosphorfreien Epoxidharzen.

Bevorzugt enthält die flammwidrige Epoxidharzmischung 5 bis 300 Gewichtsteile an weiteren Inhalts- und/oder Füllstoffen.

Bevorzugt enthält die flammwidrige Epoxidharzmischung 0,5 bis 13 Gew.-% Phosphor.

Besonders bevorzugt enthält die flammwidrige Epoxidharzmischung 1 bis 6 Gew.-% Phosphor.

Bevorzugt enthält die flammwidrige Epoxidharzmischung einen Beschleuniger.

Die vorliegende Aufgabe wird ebenfalls gelöst durch ein Verfahren zur Herstellung von flammwidrige Epoxidharzmischungen aus Epoxidharzen, phosphorhaltigen Verbindungen und einem Härter, welches dadurch gekennzeichnet ist, daß man in einem ersten Reaktionsschritt ein Epoxidharz mit einer phosphorhaltigen Verbindung der Formel I oder II umsetzt und das Reaktionsprodukt anschließend in einem zweiten Reaktionsschritt mit einem Härter in die flammwidrige Epoxidharzmischung überführt.

Bevorzugt erfolgt der erste Reaktionsschritt in einem Lösungsmittel.

Bevorzugt werden als aprotische, polare Lösungsmittel N-methylpyrrolidon, Dimethylformamid, Tetrahydrofuran, Dioxan, Dialkylether, Glykolether, Ketone und/oder Ester eingesetzt.

Geeignet sind ebenfalls Ethylenglykolether, Propylenglykolether, Butylenglykolether von Monoalkoholen mit ggf. verzweigten Alkylresten von 1 bis 6 C-Atomen sowie Ketone, wie Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden.

Ebenfalls bevorzugt werden als Lösungsmittel halogenierte Kohlenwasserstoffe, aliphatische, cycloaliphatische und/oder aromatische Kohlenwasserstoffe, einzeln oder als Gemische, eingesetzt. Bevorzugt sind dabei Hexan, Heptan, Cyclohexan, Toluol sowie Dixylole.

Bevorzugt erfolgt die Umsetzung im ersten Reaktionsschritt bei Temperaturen zwischen -10 bis +200 °C.

Besonders bevorzugt erfolgt die Umsetzung bei Temperaturen von 70 bis 130 °C.

Bevorzugt erfolgt die Umsetzung im zweiten Reaktionsschritt bei Temperaturen von 0 bis 200 °C.

Besonders bevorzugt erfolgt diese Umsetzung bei Temperaturen von 100 bis 180 °C.

Die der Erfindung zugrundeliegenden carboxyfunktionellen Phosphinsäuren bzw. Phosphonsäuren können beispielsweise durch Addition geeigneter Phosphorverbindungen an Acrylsäure oder Acrylsäureester hergestellt werden.

Die Phosphorverbindung kann vorzugsweise Methanphosphonigsäuredichlorid sein. Addition an Acrylsäure und anschließende Hydrolyse liefert Carboxyethyl-methyl-phosphinsäure (DE 25 40 283 A1) (III). Analog kann auch Phenylphosphonigsäuredichlorid verwendet werden.

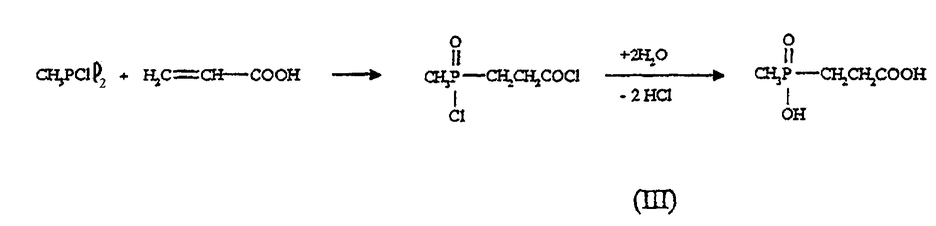

Die carboxyfunktionellen Phosphonsäuren können beispielsweise durch Addition von Dialkyl- oder Diarylphosphiten an Acrylsäureester und anschließende partielle oder vollständige Hydrolyse hergestellt werden (z. B. DE 25 18 144 A1) (IV).

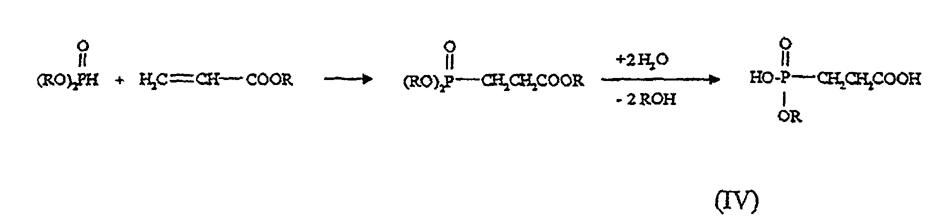

Die carboxyfunktionellen Phosphonsäuren sind auch zugänglich aus Phosphonigsäuretriestern und halogensubstituierten Acetalen nach Art der Arbuzov-Reaktion und anschließende Hydrolyse (V).

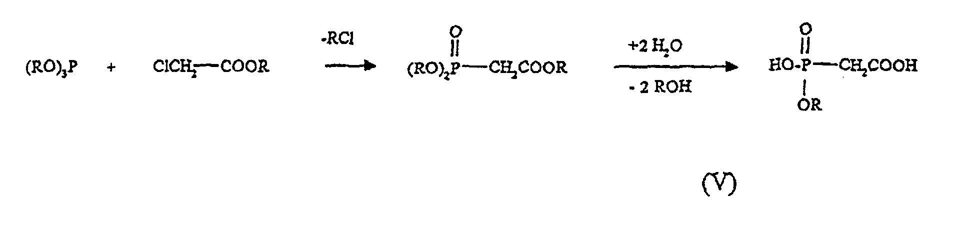

Die erfindungsgemäß eingesetzten halogenfreien Epoxidverbindungen (im folgenden auch Polyepoxidverbindungen genannt) können gesättigt oder ungesättigt sowie aliphatisch, cycloaliphatisch, aromatisch und/oder heterocyclisch sein. Sie können weiterhin solche Substituenten enthalten, die unter den Mischungs- oder Reaktionsbedingungen keine störenden Nebenreaktionen verursachen, beispielsweise Alkyl- oder Arylsubstituenten, Ethergruppierungen oder ähnliche. Es können auch Gemische verschiedener Polyepoxidverbindungen verwendet werden. Das mittlere Molekulargewicht Mₙ dieser Polyepoxidverbindungen kann bis zu etwa 9000 betragen, liegt jedoch im allgemeinen bei etwa 150 bis 4000.

Beispielsweise handelt es sich bei diesen Polyepoxidverbindungen um Polyglycidylether auf Basis von mehrwertigen, vorzugsweise zweiwertigen Alkoholen, Phenolen, Hydrierungsprodukten dieser Phenole und/oder von Novolaken (Umsetzungsprodukte von ein- oder mehrwertigen Phenolen, wie Phenol und/oder Kresole, mit Aldehyden, insbesondere Formaldehyd in Gegenwart saurer Katalysatoren), die man in bekannter Weise, beispielsweise durch Umsetzung der jeweiligen Polyole mit Epichlorhydrin, erhält.

Als mehrwertige Phenole sind hier beispielsweise zu nennen: Resorcin, Hydrochinon, 2,2-Bis(4-hydroxyphenyl)propan (Bisphenol A), Isomerengemische des Dihydroxydiphenylmethans (Bisphenol F), 4,4'-Dihydroxydiphenylcyclohexan, 4,4'-Dihydroxy-3,3'-dimethyldiphenylpropan, 4,4-Dihydroxydiphenyl, 4,4'-Dihydroxybenzophenon, Bis(4-hydroxyphenyl)1,1-ethan, Bis(4-hydroxyphenyl)1,1'-isobutan, Bis(4-hydroxy-tert.-butylphenyl)2,2-propan, Bis(2-hydroxynaphthyl)methan, 1,5-Dihydroxynaphthalin, Tris(4-hydroxyphenyl)methan, Bis(4-hydroxyphenyl)1,1'-ether. Bisphenol A und Bisphenol F sind hierbei bevorzugt

Auch die Polyglycidylether von mehrwertigen aliphatischen Alkoholen sind als Polyepoxidverbindung geeignet. Als Beispiele derartiger mehrwertiger Alkohole seien 1,4-Butandiol, 1,6-Hexandiol, Polyalkylenglykole, Glycerin, Trimethylolpropan, Bis(4-hydroxycyclohexyl)2,2-propan und Pentaerythrit genannt.

Weiter kommen als Polyepoxidverbindungen auch (Poly)glycidester in Frage, die man erhält durch Umsetzung von Epichlorhydrin oder ähnlichen Epoxyverbindungen mit einer aliphatischen, cycloaliphatischen oder aromatischen Polycarbonsäure, wie Oxalsäure, Adipinsäure, Glutarsäure, Phthal-, Isophthal-, Terephthal-, Tetrahydrophthal- oder Hexahydrophthalsäure, 2,6-Naphthalindicarbonsäure und dimerisierte Fettsäuren. Beispiele hierfür sind Terephthalsäurediglycidylester und Hexahydrophthalsäurediglycidylester. Auch Polyepoxidverbindungen, die die Epoxidgruppen in statistischer Verteilung über die Molekülkette enthalten und die durch Emulsions-Copolymerisation unter Verwendung von olefinisch ungesättigten, diese Epoxidgruppen enthaltenden Verbindungen hergestellt werden können, wie z.B. Glycidylester der Acryl- oder Methacrylsäure, können in manchen Fällen vorteilhaft eingesetzt werden.

Weitere verwendbare Polyepoxidverbindungen sind beispielsweise solche auf der Basis heterocyclischer Ringsysteme, wie z.B. Hydantoinepoxidharze, Triglycidylisocyanurat und/oder dessen Oligomeren, Triglycidyl-p-aminophenol, Triglycidyl-p-aminodiphenylether, Tetraglycidyldiaminodiphenylmethan, Tetraglycidyldiaminodiphenylether, Tetrakis(4-glycidoxyphenyl)ethan, Urazolepoxide, Uracilepoxide, oxazolidinonmodifizierte Epoxidharze. Weiterhin Polyepoxide auf der Basis von aromatischen Aminen, wie Anilin, beispielsweise N,N-Diglycidylanilin, Diaminodiphenylmethan und N,N'-Dimethylaminodiphenylmethan oder -sulfon. Weitere geeignete Polyepoxidverbindungen sind im "Handbook of Epoxy Resins" von Henry Lee und Kris Neville, McGraw-Hill Book Company, 1967, in der Monographie von Henry Lee "Epoxy Resins", American Chemical Society, 1970, in Wagner/Sarx, "Lackkunstharze", Carl Hanser Verlag (1971), 5. Auflage, 174 ff., in der "Angew. Makromol. Chemie", Bd. 44 (1975), Seiten 151 bis 163, in der DE 27 57 733 A1 sowie in der EP 0 384 939 A1 beschrieben, auf die hiermit Bezug genommen wird.

Bevorzugt eingesetzte Polyepoxidverbindungen sind Bisglycidylether auf Basis von Bisphenol A, Bisphenol F und Bisphenol S (Umsetzungsprodukte dieser Bisphenole und Epichlor(halogen)hydrin) oder deren Oligomere, Polyglycidylether von Phenol/Formaldehyd- und/oder Kresol/Formaldehyd-Novolake sowie Diglycidylester der Phthal-, Isophthal-, Terephthal-, Tetrahydrophthal- und/oder Hexahydrophthalsäure sowie der Trimellithsäure, N-Glycidylverbindungen von aromatischen Aminen und heterocyclischen Stickstoffbasen, wie N,N-Diglycidylanilin, N,N,O-Triglycidyl-p-aminophenol, Triglycidylisocyanurat und N,N,N',N'-Tetraglycidylbis(p-aminophenyl)methan, Hydrantoin-Epoxidharze und Aracid-Epoxidharze sowie Di- und Polyglycidylverbindungen von mehrwertigen aliphatischen Alkoholen, wie 1,4-Butandiol, Trimethylolpropan und Polyalkylenglykolen.

Des weiteren sind auch oxazolidinonmodifizierte Epoxidharze geeignet. Derartige Verbindungen sind bereits bekannt (siehe: "Angew. Makromol. Chem.", Bd. 44 (1975), Seiten 151 bis 163, sowie US-PS 3 334 110); beispielhaft sei hierfür das Umsetzungsprodukt von Bisphenol-A-diglycidylether mit Diphenylmethandiisocyanat (in Gegenwart eines geeigneten Beschleunigers) genannt. Die Polyepoxidharze können bei der Herstellung der erfindungsgemäßen Überzugsmasse einzeln oder im Gemisch vorliegen.

Der Ausdruck "Härten", wie er hier gebraucht wird, bedeutet die Umwandlung der löslichen, schmelzbaren Polyepoxide in feste, unlösliche und unschmelzbare, dreidimensional vernetzte Produkte, in der Regel unter gleichzeitiger Formgebung, etwa zu Imprägnierungen, Beschichtungen und Verklebungen.

Als Härter können bespielsweise aliphatische, cycloaliphatische, aromatische und heterocyclische Amine, wie Bis(4-aminophenyl)methan, Anilin-Formaldehyd-Harze, Bis(4-aminophenyl)sulfon, Ethylendiamin, Propan-1,3-diamin, Hexamethylendiamin, Diethylentriamin, Triethylentetramin, 2,2,4-Trimethylhexan-1,6-diamin, m-Xylylendiamin, Bis(4-aminocyclohexyl)methan, 2,2-Bis(4-aminocyclohexyl)propan, 3-Aminomethyl-3,55-trimethylcyclohexylamin (Isophorondiamin), Polyamidoamine, Polyphenole, wie Hydrochinon, Resorcin, 2,2-Bis(4-hydroxyphenyl)propan (Bisphenol A) und Phenol-Aldehyd-Harze, Polycarbonsäuren und deren Anhydride, wie zum Beispiel Phtalsäureanhydrid, Tetrahydrophtalsäueanhydrid, Hexahydrophtalsäureanhydrid, Pyromellithsäuredianhydrid eingesetzt werden. Darüber hinaus können auch katalytisch wirkende Härtungsmittel wie Cyanguanidine oder Friedel-Crafts-Katalysatoren Bortrifluorid verwendet werden.

Werden Amine als Härtungsmittel verwendet, so werden diese normalerweise in 0,75 bis 1,25 Äquivalenten pro Epoxidäquivalent eingesetzt. Bei Polycarbonsäuren und deren Anhydriden werden 0,4 bis 1,1 Äquivalente pro Epoxidäquivalent verwendet.

Als Beschleuniger kommen vor allem Imidazolderivate, beispielsweise 2-Methylimidazol, 2-Phenylimidazol und 2-Heptadecylimidazol in Frage; weiterhin Phosphine, Metallseifen und Acetylacetonate.

Als Reaktiv-Verdünner kommen beispielsweise mono- oder polyfunktionelle, niedermolekulare Alkohole, die mit Epichlorhydrin umgesetzt werden, in Frage.

Durch Variation des Äquivalentverhältnisses von Polyepoxidverbindung zu carboxyfunktioneller Phosphinsäure/Phosphonsäure läßt sich der Phosphorgehalt des erfindungsgemäßen Harzes einstellen. Bevorzugt liegt das Äquivalentverhältnis zwischen 1: 0,1 und 1: 0,8 und besonders bevorzugt zwischen 1:0,1 und 1:0,4.

Falls Lösemittel eingesetzt werden, so sind diese aprotisch und vorzugsweise polar. Beispiele hierfür sind:
N-methylpyrrolidon, Dimethylformamid, Ether wie etwa Diethylether, Tetrahydrofuran, Dioxan, Ethylglykolether, Propylenglykolether, Butylglykolether von Monoalkoholen mit einem ggf. verzweigten Alkylrest von 1 bis 6 Kohlenstoffatomen.

Andere Lösungsmittel sind z.B. Ketone, wie etwa Aceton, Methylethylketon, Methylisopropylketon, Methylisobutylketon, Cyclohexanon und ähnliche, aber auch Ester, wie Ethylacetat, Butylacetat, Ethylenglycolacetat und Methoxypropylacetat können eingesetzt werden. Weitere geeignete Lösungsmittel sind halogenierte Kohlenwasserstoffe sowie cycloaliphatische und/oder aromatische Kohlenwasserstoffe, bevorzugt sind dabei Hexan, Heptan, Cyclohexan, Toluol sowie Dixylole. Es ist möglich, diese Lösemittel einzeln oder im Gemisch einzusetzen.

Bevorzugt sind die Epoxidharz-Formmassen durch Glasgewebe oder Glasfasern verstärkt. Die Epoxidharz-Formmassen können auch mit Füllstoffen wie Quarzmehl oder Aluminiumoxidhydrat ausgerüstet werden.

Die Prüfung des Brandverhaltens wurde nach der Vorschrift von Underwriters Laboratories "Test for Flammability of Plastic Materials - UL 94" in der Fassung vom 02.05.1975 an Prüfkörpern von 127 mm Länge, 12,7 mm Breite und verschiedener Dicke durchgeführt. Der Sauerstoffindex wurde in einer Apparatur nach ASTM-D 2863-74 bestimmt.

Die erfindungsgemäßen Epoxidharz-Formmassen können zur Oberflächenbeschichtung verwendet werden- Sie können für den Verguß elektrischer Bauteile, für Laminate sowie für Klebstoffe verwendet werden.

Nachfolgend wird die Erfindung durch Beispiele erläutert:

### I.

### Herstellung der phosphormodifizierten Epoxidharze

### Beispiel 1 (mit 2-Carboxyethan-methan-phosphinsäure)

In einem 500 ml Fünfhalskolben mit Rückflußkühler, Rührerwelle, Thermometer und Feststoffdosierung werden 200 g eines Bisphenol-A-bisglycidylethers mit einem Epoxidwert von 5,5 mol/kg vorgelegt. Bei einer Badtemperatur von 100 °C werden portionsweise 41 g (0,27 mol) 2-Carboxyethan-methan-phosphinsäure dazugegeben. Nach 30 min wird eine klare Lösung mit einem Epoxidwert von 3,1 mol/kg erhalten. Nach weiteren 4 h Rühren bei 100 °C wird ein bei Raumtemperatur festes Epoxidharz mit einem Epoxidwert von 2,4 mol/kg und einem Phosphorgehalt von 3,5 Gew.-% erhalten.

### Beispiel 2 (mit 2-Carboxyethan-methan-phosphinsäure)

In einem 500 ml Fünfhalskolben mit Rückflußkühler, Rührerwelle, Thermometer und Feststoffdosierung werden 100 g eines Bisphenol-A-bisglycidylethers mit einem Epoxidwert von 5,5 mol/kg vorgelegt. Bei einer Badtemperatur von 100 °C werden portionsweise 30,8 g (0,2 mol) 2-Carboxyethan-methan-phosphinsäure dazugegeben. Nach weiteren 2,5 h Rühren bei 100 °C wird ein bei Raumtemperatur festes Epoxidharz mit einem Epoxidwert von 1,3 mol/kg und einem Phosphorgehalt von 4,7 Gew.-% erhalten.

### Beispiel 3 (mit 2-Carboxyethan-methan-phosphinsäure)

In einem 2 1 Fünfhalskolben mit Rückflußkühler, Rührerwelle, Thermometer und Feststoffdosierung werden 842 g eines Bisphenol-A-bisglycidylethers mit einem Epoxidwert von 5,5 mol/kg und 234,8 g 2-Carboxyethan-methan-phosphinsäure vorgelegt. Es wird 1 h bei 95 °C gerührt. Anschließend werden 335 ml Methylethylketon während 2 h bei 95 °C zudosiert. Nach weiteren 2 h Rühren wird eine 80%ige Lösung eines phosphormodifizierten Epoxidharzes erhalten. Der Epoxidwert beträgt 1,7 mol/kg, der Phosphorgehalt 3,4 Gew.-%. Nach 12 Tagen Lagerung bei Raumtemperatur beträgt der Epoxidwert 1,7 mol/kg.

### Beispiel 4 (mit 2-Carboxyethan-phosphonsäure-monomethylester)

In einem 500 ml Fünfhalskolben mit Rückflußkühler, Rührerwelle, Thermometer und Feststoffdosierung werden 264 g eines Bisphenol-A-bisglycidylethers mit einem Epoxidwert von 5,5 mol/kg vorgelegt. Bei einer Badtemperatur von 120°C und leichtem Vakuum 333 mbar (250 mm) werden während 30 min 67 g (0,36 mol) 2-Carboxyethan-phosphon-säuremonomethylester, gelöst in 50 ml Methylethylketon, dazugegeben. Das Lösemittel wird abdestilliert. Nach weiteren 30 min Rühren bei 120 °C werden 328,7 g eines bei Raumtemperatur festen Epoxidharzes mit einem Epoxidwert von 1,3 mol/kg und einem Phosphorgehalt von 3,4 Gew.-% erhalten.

### Beispiel 5 (mit Carboxymethan-phosphonsäure-monoethylester)

In einem 250 ml Fünfhalskolben mit Rückflußkühler, Rührerwelle, Thermometer und Feststoffdosierung werden 79g eines Bisphenol-A-bisglycidylethers mit einem Epoxidwert von 5,5 mol/kg und 20 ml Methylethylketon vorgelegt. Bei einer Badtemperatur von 75 °C werden während 30 min 18,25 g Carboxymethan-phosphonsäure-monoethylester (0,1mol), gelöst in 15 ml Methylethylketon, dazugegeben. Das Lösemittel wird abdestilliert. Nach weiteren 2 h min Rühren bei 75 °C werden 100,7 g eines bei Raumtemperatur festen Epoxidharzes mit einem Epoxidwert von 1,8 mol/kg und einem Phosphorgehalt von 3,1 Gew.-% erhalten.

### Beispiel 6 (mit 2-Carboxyethan-phenyl-phosphinsäure)

In einem 250 ml Fünfhalskolben mit Rückflußkühler, Rührerwelle, Thermometer und Feststoffdosierung werden 103 g eines Bisphenol-A-bisglycidylethers mit einem Epoxidwert von 5,5 mol/kg vorgelegt. Bei einer Badtemperatur von 120 °C werden portionsweise 28 g (0,14 mol) 2-Carboxyethan-phenyl-phosphinsäure dazugegeben. Nach 30 min wird eine klare Lösung mit einem Epoxidwert von 2,7 mol/kg erhalten. Nach weiteren 30 min Rühren bei 120 °C wird ein bei Raumtemperatur festes Epoxidharz mit einem Epoxidwert von 2,5 mol/kg und einem Phosphorgehalt von 3,3 Gew.-% erhalten.

### Beispiel 7 (mit 2-Carboxyethan-phenyl-phosphinsäure)

In einem 250 ml Fünfhalskolben mit Rückflußkühler, Rührerwelle, Thermometer und Feststoffdosierung werden 100g eines Bisphenol-A-bisglycidylethers mit einem Epoxidwert von 5,5 mol/kg vorgelegt. Bei einer Badtemperatur von 120 °C werden portionsweise 41,1 g (0,2 mol) 2-Carboxyethan-phenyl-phosphinsäure dazugegeben. Nach 30 min wird eine klare Lösung erhalten. Nach weiteren 30min Rühren bei 120 °C wird ein bei Raumtemperatur festes Epoxidharz mit einem Epoxidwert von 1,5 mol/kg und einem Phosphorgehalt von 4,5 Gew.-% erhalten.

### II.

### Herstellung der Epoxidharz-Formmassen

### Beispiel 8

100 g phoshormodifiziertes Epoxidharz nach Beispiel 1 werden bei 120 °C aufgeschmolzen und mit 3,1 g mikronisiertem Dicyandiamid (®Dyhard 100 SF, SKW Trostberg AG) und 0,3 g Imidazol-Beschleuniger (®Dyhard MI, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

### Beispiel 9

100 g phosphormodifziertes Epoxidharz nach Beispiel 2 werden bei 120 °C aufgeschmolzen und mit 22 g Methylcyclohexandicarbonsäureanhydrid und 0,4 g Benzyldimethylamin intensiv vermischt und in einer Teflonform von 200x200x2 mm im Trockenschrank bei 120 - 180 °C während 4 h ausgehärtet. Aus dieser Formmasse wurden Prüfkörper von 127 mm Länge und 12,7 mm Breite gesägt.

### Beispiel 10

120 g phoshormodifiziertes Epoxidharz nach Beispiel 6 werden bei 120 °C aufgeschmolzen und mit 3,3 g mikronisiertem Dicyandiamid (®Dyhard 100 SF, SKW Trostberg AG) und 0,3 g Imidazol-Beschleuniger (®Dyhard MI, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

### Beispiel 11

100 g phosphormodifiziertes Epoxidharz nach Beispiel 7 werden bei 120 °C aufgeschmolzen und mit 25 g Methylcyclohexandicarbonsäureanhydrid und 0,4 g Benzyldimethylamin intensiv vermischt und in einer Teflonform von 200x200x2 mm im Trockenschrank bei 120 - 180 °C während 4 h ausgehärtet. Aus dieser Formmasse wurden Prüfkörper von 127 mm Länge und 12,7 mm Breite gesägt.

### Beispiel 12 (Vergleichsbeispiel)

150 g eines Bisphenol-A-bisglycidylethers (®Beckopox EP 140) mit einem Epoxidwert von 0,53 mol/100g werden und mit 6,9 g mikronisiertem Dicyandiamid (®Dyhard 100 SF, SKW Trostberg AG) und 0,3 g Imidazol-Beschleuniger (®Dyhard MI, Methylimidazol, SKW Trostberg AG) intensiv vermischt und in einer Teflonform von 200x200x2 mm im Trockenschrank bei 150 - 180 °C während 4 h ausgehärtet. Aus dieser Formmasse wurden Prüfkörper von 127 mm Länge und 12,7 mm Breite gesägt.

Die Prüfung des Brandverhaltens wurde nach der Vorschrift von Underwriters Laboratories "Test for Flammability of Plastic Materials - UL 94" in der Fassung vom 02.05.1975 an Prüfkörpern von 127 mm Länge, 12,7 mm Breite und 2 mm Dicke durchgeführt. Der Sauerstoffindex wurde in einer Apparatur nach ASTM-D 2863-74 bestimmt.

Tabelle 1 zeigt die Ergebnisse der Sauerstoffindex-Messungen und der Brandtests nach UL 94.

| Epoxidharz-Formmasse | Sauerstoffindex | Nachbrennzeit | UL 94 Klassifizierung |
|---|---|---|---|
| Beispiel 8 | 38,1 | <1', <1' | V-0 |
| Beispiel 9 | 26,1 | <1', <1' | V-0 |
| Beispiel 10 | 29,2 | <2', <2' | V-0 |
| Beispiel 11 | 25,3 | <1', <1' | V-0 |
| Beispiel 12 (Vergleichsbeispiel) | 20,5 | verbrannt | n. k.* |

| | | | |
|---|---|---|---|
| *n. k. = nicht klassifizierbar | | | |

## Patentansprüche

1. Flammwidrige Epoxidharzmischungen aus Epoxidharzen, phosphorhaltigen Verbindungen und einem Härter, **dadurch gekennzeichnet, dass** sie auf 100 Gewichtstelle Epoxidharz 10 bis 100 Gewichtsteile phosphorhaltiger Verbindungen der Formel I oder II, 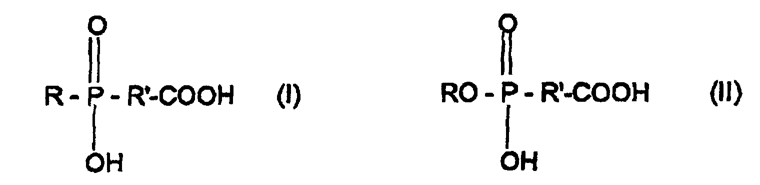 in der R eine geradlinige oder verzweigte Alkyl-, Cycloalkyl-, Aryl- oder Alkylarylgruppe mit 1 bis 18 C-Atomen oder Wasserstoff, R' eine geradlinige oder verzweigte Alkylen-, Cycloalkylen-, Arylen- oder Alkylarylengruppe mit 1 bis 18 C-Atomen bedeutet, enthält und das Gesamtgwichtsverhältnis von Epoxidharz und phosphorhaltiger Verbindung nach Formel I oder II zu Härter (1 bis 10) zu 1 beträgt.

2. Flammwidrige Epoxidharzmischung nach Anspruch 1, **dadurch gekennzeichnet**, **dadurch gekennzeichnet, dass** sie halogenfrei ist.

3. Flammwidrige Epoxidharzmischung nach Anspruch 1 oder 2, **dadurch gekennzeichnet, dass** sie 5 bis 300 Gewichtstelle an phosphorfreien Epoxidharzen enthält.

4. Flammwidrige Epoxidharzmischung nach einem oder mehreren der Ansprüche 1 bis 3, **dadurch gekennzeichnet, dass** sie 5 bis 300 Gewichtsteile an weiteren Inhaltsund/oder Füllstoffen enthält.

5. Flammwidrige Epoxidharzmischung nach einem oder mehreren der Ansprüche 1 bis 4, **dadurch gekennzeichnet, dass** sie 0,5 bis 13 Gew.-% Phosphor enthält.

6. Flammwidrige Epoxidharzmischung nach einem oder mehreren der Ansprüche 1 bis 5, **dadurch gekennzeichnet, dass** sie 1 bis 6 Gew.-% Phosphor enthält.

7. Flammwidrige Epoxidharzmischung nach einem oder mehreren der Ansprüche 1 bis 6, **dadurch gekennzeichnet, dass** sie einen Beschleuniger enthält.

8. Verfahren zur Herstellung von flammwidrigen Epoxidharzmischungen aus Epoxidharzen, phosphorhaltigen Verbindungen und einem Härter, **dadurch gekennzeichnet, dass** man in einem ersten Reaktionsschritt ein Epoxidharz mit einer phosphorhaltigen Verbindung der Formel I oder II umsetzt und das Reaktionsprodukt anschließend in einem zweiten Reaktionsschritt mit einem Härter in die flammwidrige Epoxidharzmischung überführt.

9. Verfahren nach Anspruch 8, **dadurch gekennzeichnet, dass** der erste Reaktionsschritt in einem Lösungsmittel erfolgt.

10. Verfahren nach Anspruch 9, **dadurch gekennzeichnet dass** aprotische, polare Lösungsmittel, wie N-methylpyrrolidon, Dimethylformamid, Tetrahydrofuran, Dioxan, Dialkylether, Glykolether, Ketone und/oder Ester eingesetzt werden.

11. Verfahren nach Anspruch 9, **dadurch gekennzeichnet, dass** als Lösungsmittel halogenierte Kohlenwasserstoffe, aliphatische, cycloaliphatische und/oder aromatische Kohlenwasserstoffe, einzeln oder als Gemische, eingesetzt werden.

12. Verfahren nach einem oder mehreren der Ansprüche 8 bis 11, **dadurch gekennzeichnet, dass** die Umsetzung im ersten Reaktionsschritt bei Temperaturen zwischen -10 bis +200°C erfolgt.

13. Verfahren nach Anspruch 12, **dadurch gekennzeichnet, dass** die Umsetzung bei Temperaturen von 70 bis 130°C erfolgt.

14. Venahren nach einem oder mehreren der Ansprüche 9 bis 13, **dadurch gekennzeichnet, dass** die Umsetzung Im zweiten Reaktionsschritt bei Temperaturen von 0 bis 200°C erfolgt.

15. Verfahren nach Anspruch 14, **dadurch gekennzeichnet, dass** die Umsetzung bei Temperaturen von 100 bis 180°C erfolgt.

16. Verwendung von Epoxidharzmischungen nach einem oder mehreren der Ansprüche 1 bis 7 oder hergestellt nach einem oder mehreren der Ansprüche 8 bis 15 in Beschichtungsmaterialien.

17. Prepregs und Verbundwerkstoffe auf der Basis von anorganischen oder organischen Verstärkungsmaterialien in der Form von Fasern, Vliesen oder Geweben, hergestellt aus Epoxidharzmischungen nach einem oder mehreren der Ansprüche 1 bis 7 oder erhalten nach dem Verfahren gemäß einem oder mehreren der Ansprüche 8 bis 15.

18. Leiterplatten aus Prepregs, hergestellt aus Glasfasergeweben und Epoxidharzmischungen nach einem oder mehreren der Ansprüche 1 bis 7 oder erhalten nach dem Verfahren gemäß einem oder mehreren der Ansprüche 8 bis 15.

## Claims

1. A flame-resistant epoxy resin mixture comprising epoxy resins, phosphorus-containing compounds and a hardener, which comprises from 10 to 100 parts by weight of phosphorus-containing compounds of the formula I or II per 100 parts by weight of epoxy resin 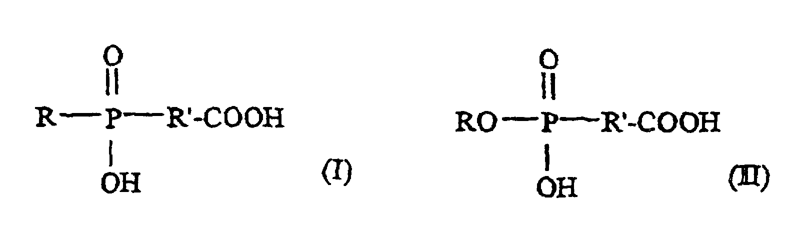 in which R is a linear or branched alkyl, cycloalkyl, aryl or alkylaryl group having 1 to 18 carbon atoms, or is hydrogen, and R' is a linear or branched alkylene, cycloalkylene, arylene or alkyl-arylene group having 1 to 18 carbon atoms, and the overall weight ratio of epoxy resin and phosphorus-containing compound of formula I or II to hardener is (1 to 10) to 1.

2. A flame-resistant epoxy resin mixture as claimed in claim 1, which is free from halogen.

3. A flame-resistant epoxy resin mixture as claimed in claim 1 or 2, which contains from 5 to 300 parts by weight of phosphorus-free epoxy resins.

4. A flame-resistant epoxy resin mixture as claimed in one or more of claims 1 to 3, which contains from 5 to 300 parts by weight of further ingredients and/or fillers.

5. A flame-resistant epoxy resin mixture as claimed in one or more of claims 1 to 4, which contains from 0.5 to 13 % by weight of phosphorus.

6. A flame-resistant epoxy resin mixture as claimed in one or more of claims 1 to 5, which contains from 1 to 6 % by weight of phosphorus.

7. A flame-resistant epoxy resin mixture as claimed in one or more of claims 1 to 6, which contains an accelerator.

8. A process for preparing a flame-resistant epoxy resin mixture comprising epoxy resins, phosphorus-containing compounds and a hardener, which in a first reaction step comprises reacting an epoxy resin with a phosphorus-containing compound of the formula I or II and then, in a second reaction step, comprises converting the reaction product into a flame-resistant epoxy resin mixture, with a hardener.

9. The process as claimed in claim 8, wherein the first reaction step takes place in a solvent.

10. The process as claimed in claim 9, wherein aprotic polar solvents such as N-methylpyrrolidone, dimethylformamide, tetrahydrofuran, dioxane, dialkyl ethers, glycol ethers, ketones and/or esters are employed.

11. The process as claimed in claim 9, wherein solvents employed are halogenated hydrocarbons, aliphatic, cycloaliphatic and/or aromatic hydrocarbons, individually or as mixtures.

12. The process as claimed in one or more of claims 8 to 11, wherein the reaction in the first reaction step takes place at temperatures of between -10 and +200°C.

13. The process as claimed in claim 12, wherein the reaction takes place at temperatures from 70 to 130°C.

14. The process as claimed in one or more of claims 9 to 13, wherein the reaction in the second reaction step takes place at temperatures from 0 to 200°C.

15. The process as claimed in claim 14, wherein the reaction takes place at temperatures from 100 to 180°C.

16. The use of an epoxy resin mixture as claimed in one or more of claims 1 to 7 or prepared as claimed in one or more of claims 8 to 15 in coating materials.

17. A prepreg or laminate based on inorganic or organic reinforcing materials in the form of fibers, nonwovens or woven fabrics, prepared from an epoxy resin mixture as claimed in one or more of claims 1 to 7 or obtained by the process as claimed in one or more of claims 8 to 15.

18. A printed circuit board made from a prepreg produced from glass fiber cloths and an epoxy resin mixture as claimed in one or more of claims 1 to 7 7 or obtained by the process as claimed in one or more of claims 8 to 15.

## Revendications

1. Mélanges de résines époxydes ininflammables à partir de résines époxydes, de composés phosphorés et d'un durcisseur, **caractérisés en ce qu'**ils contiennent, pour 100 parties en poids de résine époxyde, de 10 à 100 parties en poids de composés phosphorés de formules I ou II 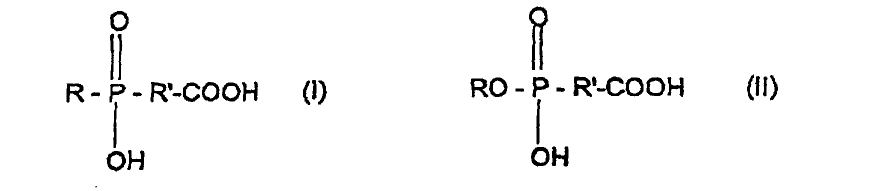 où R représente un groupe alkyle à chaîne droite ou ramifiée, cycloalkyle, aryle ou alkylaryle présentant 1 à 18 atomes de carbone ou un atome d'hydrogène, R' représente un groupe alkylène à chaîne droite ou ramifiée, cycloalkylène, arylène ou alkylarylène présentant 1 à 18 atomes de carbone,
et le rapport pondéral total de la résine époxyde et du composé phosphoré de formules I ou II au durcisseur est de (1 à 10) à 1.

2. Mélange de résines époxydes ininflammable selon la revendication 1, **caractérisé en ce qu'**il est dépourvu d'halogène.

3. Mélange de résines époxydes ininflammable selon la revendication 1 ou 2, **caractérisé en ce qu'**il contient de 5 à 300 parties en poids de résines époxydes dépourvues de phosphore.

4. Mélange de résines époxydes ininflammable selon une ou plusieurs des revendications 1 à 3, **caractérisé en ce qu'**il contient de 5 à 300 parties en poids d'autres additifs et/ou charges.

5. Mélange de résines époxydes ininflammable selon une ou plusieurs des revendications 1 à 4, **caractérisé en ce qu'**il présente une teneur de 0,5 à 13 % en poids en phosphore.

6. Mélange de résines époxydes ininflammable selon une ou plusieurs des revendications 1 à 5, **caractérisé en ce qu'**il contient 1 à 6 % en poids de phosphore.

7. Mélange de résines époxydes ininflammable selon une ou plusieurs des revendications 1 à 6, **caractérisé en ce qu'**il contient un accélérateur.

8. Procédé pour la préparation de mélanges de résines époxydes ininflammables à partir de résines époxydes, de composés phosphorés et d'un durcisseur, **caractérisé en ce qu'**on fait réagir dans une première étape réactionnelle une résine époxyde sur un composé phosphoré de formules I ou II et ensuite on transforme le produit réactionnel dans une seconde étape réactionnelle en le mélange de résines époxydes ininflammable à l'aide d'un durcisseur.

9. Procédé selon la revendication 8, **caractérisé en ce qu'**on met en oeuvre la première étape réactionnelle dans un solvant.

10. Procédé selon la revendication 10, **caractérisé en ce qu'**on utilise des solvants aprotiques, polaires, comme la N-méthylpyrrolidone, le diméthylformamide, le tétrahydrofuranne, le dioxanne, l'éther dialkylique, l'éther de glycol, des cétones et/ou esters.

11. Procédé selon la revendication 9, **caractérisé en ce qu'**on utilise comme solvant des hydrocarbures halogénés, des hydrocarbures aliphatiques, cycloaliphatiques et/ou aromatiques, seuls ou en mélange.

12. Procédé selon une ou plusieurs des revendications 8 à 11, **caractérisé en ce qu'**on met en oeuvre la réaction dans la première étape réactionnelle à une température comprise entre -10 à +200°C.

13. Procédé selon la revendication 12, **caractérisé en ce qu'**on met en oeuvre la réaction à une température de 70 à 130°C.

14. Procédé selon une ou plusieurs des revendications 9 à 13, **caractérisé en ce qu'**on met en oeuvre la réaction dans la seconde étape réactionnelle à une température de 0 à 200°C.

15. Procédé selon la revendication 14, **caractérisé en ce qu'**on met en oeuvre la réaction à une température de 100 à 180°C.

16. Utilisation de mélanges de résines époxydes selon une ou plusieurs des revendications 1 à 7 ou préparés selon une ou plusieurs des revendications 8 à 15 dans des matières de revêtement.

17. Prépregs et matériaux composites à base de matériaux de renfort inorganiques ou organiques sous forme de fibres, de voiles ou de tissus, préparés à partir de mélanges de résines époxydes selon une ou plusieurs des revendications 1 à 7 ou obtenus selon le procédé selon une ou plusieurs des revendications 8 à 15.

18. Circuits imprimés en prépregs, préparés à partir de toiles de fibres de verre et de mélanges de résines époxydes selon une ou plusieurs des revendications 1 à 7 ou obtenus à l'aide du procédé selon une ou plusieurs des revendications 8 à 15.
